# EUROPEAN PATENT SPECIFICATION

(11) **EP 1 797 607 B1**
(45) Date of publication and mention of the grant of the patent: **23.01.2008**
(21) Application number: 05812591.5
(22) Date of filing: 14.10.2005
(51) Int. Cl.: H01L 51/52, F21V 5/02, G02B 26/08

(54) **FLAT-PANEL AREA ILLUMINATION SYSTEM**
BELEUCHTUNGSSYSTEM FÜR FLACHBILDSCHIRMBEREICH
SYSTEME D'ECLAIRAGE A SURFACE PLATE

(30) Priority: 15.10.2004 US 966210
(43) Date of publication of application: 20.06.2007
(73) Proprietor: Eastman Kodak Company, Rochester, New York 14650-2201 (US)
(72) Inventor: COK, Ronald Steven, Rochester, New York 14625 (US)
(74) Representative: Haile, Helen Cynthia
(86) International application number: PCT/US2005/037289
(87) International publication number: WO 2006/044818

(56) References cited:
- EP-A- 1 403 908
- US-A- 5 771 328
- US-A1- 2001 053 075
- US-A1- 2004 042 198

## Description

### FIELD OF THE INVENTION

This invention relates to illumination provided by flat-panel lamps and, in particular, to means for directing the light from a flat-panel lamp.

### BACKGROUND OF THE INVENTION

Flat-panel light sources are a new illumination technology and are notable for their form factor and area light emission. Such lamps are typically relatively thin, for example a few millimeters thick, and emit light over most of the lamp's surface. The light is typically emitted in every direction from the surface of the lamp. However, in many applications, it is preferred that light be preferentially directed, for example toward a wall, ceiling, or floor.

Existing commercially available lighting sources such as incandescent and fluorescent bulbs typically rely upon a lighting fixture that is used to direct the light. Such lamps typically emit light from a limited area, such as a filament, cylindrical bulb, or solid-state light emitting diode (LED) and must be very bright to provide adequate illumination. Hence, light-directing shades are necessary to provide a pleasing environment without glare. For example, incandescent desk or floor lamps usually have a shade that directs the light up toward the ceiling and down toward the floor. Wall sconces typically direct their light along a wall. Ceiling lamps often provide directed spot or task lighting, or include reflectors that direct light horizontally toward a wall. Such lamps are bulky, especially when combined with shades or reflectors. The choice of light direction is dependent upon the application and location of a lamp, as well as the technology used to provide the illumination.

Although not prevalent, flat-panel lamps are known in the industry and may employ organic light emitting diodes to provide light. For example, US20040061439 A1 entitled "OLED Lamp" by Cok published 20040401 describes an OLED lamp that includes a substrate; a non-pixellated OLED formed on the substrate, the OLED including a first electrode formed on the substrate and extending from a first edge of the substrate toward a second opposite edge of the substrate, an OLED light emitting structure formed on top of the first electrode, leaving exposed a portion of the first electrode near the first edge of the substrate, and a second electrode formed over the OLED light emitting structure and extending to the second edge of the substrate; and an encapsulating cover located over the non-pixellated OLED leaving exposed portions of the first electrode and the second electrode for making electrical contact to the lamp. Such OLED lamps may include fixtures, have rigid or flexible substrates, and may include lamp shades, for example as taught in US20030222559 A1 entitled "Lighting apparatus with flexible OLED area illumination light source and fixture" by the same author and published 20031204.

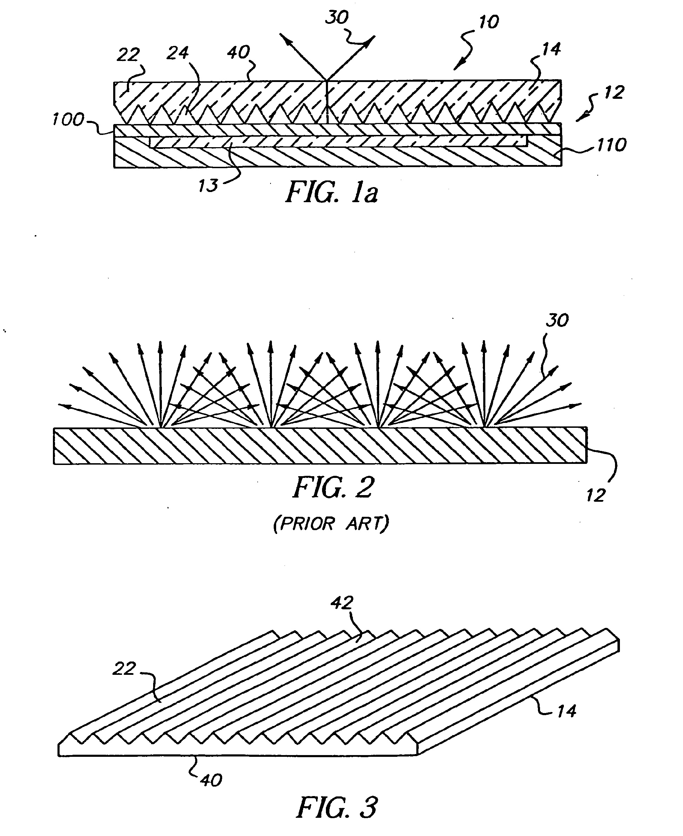

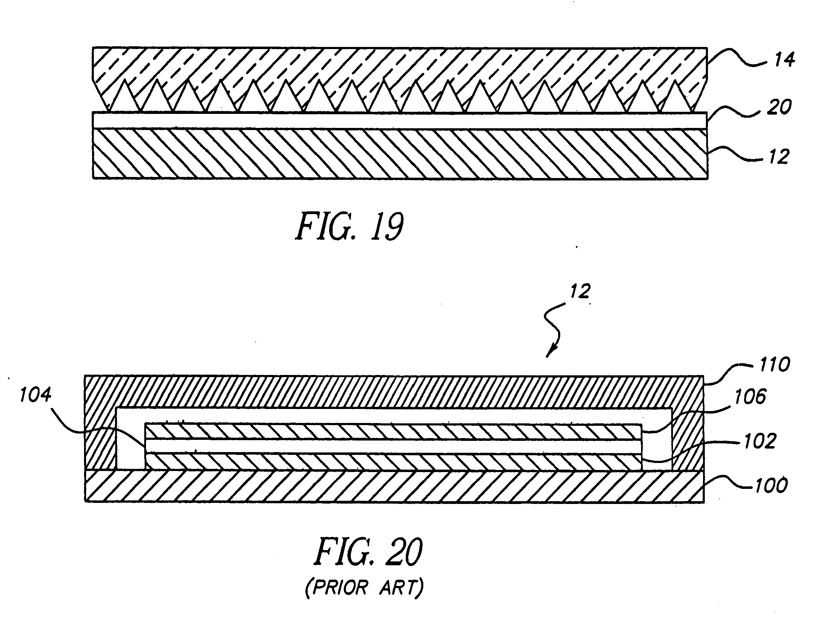

A simplified illustration of such prior-art OLED flat-panel lamps is shown in Fig. 20. Referring to Fig. 20, a flat-panel lamp **12** includes a substrate **100** on which is deposited a first electrode **102,** one or more organic layers **104** and a second electrode **106.** The flat-panel lamp **12** is encapsulated with a cover **110.** Upon the application of a voltage across the electrodes **102** and **106,** current flows through the organic layer(s) **104** to produce light that is emitted through either the substrate **100** or cover **110,** depending on the design of the device. The light emitting area is defined by the extent of the electrodes and organic layer(s) **102,104,** and **106** over the substrate **100.** Referring to Fig. 2, the light **30** emitted is emitted approximately equally in every direction from the entire light-emitting surface of the lamp **12.** The lengths of the arrows representing light rays in Fig. 2 are approximately equal and graphically illustrate that the amount of light emitted in the direction of the arrows is approximately equal. Although these lamps emit light over a much greater area than do conventional lamps, they can still be very bright and may require shading. Moreover, some lighting designs can require that the emitted light be directed in particular directions.

Optical films, including brightness enhancement films and light turning films, are described, e.g., in USPs 6,707,611, 6,752,505, 6,760,157. Such films are typically employed to collimate or diffuse light in various applications, e.g. in LCD device backlights having side or back illumination with fluorescent or point-source LED emitters.

As described in the prior art, flat-panel lamps do not maintain a flat and thin configuration when coupled with a light-directing element, for example a shade or other fixture. There is a need therefore for an improved flat-panel area illumination system that overcomes this objection while providing directed lighting.

### SUMMARY OF THE INVENTION

The need is met in accordance with one embodiment of the invention by providing a flat-panel area illumination system, comprising: a) a flat-panel lamp having a substrate and one or more non-pixellated light-emitting areas formed on the substrate emitting light in every direction from at least one light-emitting side of the lamp; and b) a light-directing optical film located on the at least one light-emitting side over the light-emitting area of the flat-panel lamp, wherein the light-directing optical film preferentially directs light away from a direction perpendicular to the surface of the light-emitting side of the flat-panel lamp.

### ADVANTAGES

The flat-panel lamp system of the present invention provides light direction capability for a flat-panel OLED lamp while preserving a thin profile.

### BRIEF DESCRIPTION OF THE DRAWINGS

Fig. 1a is a schematic diagram showing a flat-panel area illumination system according to one embodiment of the present invention;
Fig. 1b is a schematic diagram showing a flat-panel area illumination system according to another embodiment of the present invention;
Fig. 2 is a prior-art schematic diagram of a flat-panel lamp;
Fig. 3 is a perspective view of a light-directing optical film according to one embodiment of the present invention;
Fig. 4 is a schematic diagram showing a flat-panel area illumination system according to an alternative embodiment of the present invention;
Figs. 5a-b are perspective views of light directing structures;
Figs. 6a-d are micrograph views of light directing structures;
Fig. 7 is a schematic diagram illustrating the light output from the embodiment of Fig. 1a;
Fig. 8 is a schematic diagram showing a flat-panel area illumination system and light output according to another alternative embodiment of the present invention;
Fig. 9 is a schematic diagram showing a flat-panel area illumination system having multiple light-directing optical films according to another alternative embodiment of the present invention;
Fig. 10 is a top view of a light-directing optical film according to an embodiment of the present invention;
Fig. 11 is a top view of a light-directing optical film according to another alternative embodiment of the present invention;
Fig. 12 is a top view of a light-directing optical film according to yet another alternative embodiment of the present invention;
Fig. 13 is a graph illustrating the light output of an OLED flat-panel lamp;
Fig. 14 is a graph illustrating the light output of a flat-panel area illumination system according to the embodiment of Fig. 1a;
Fig. 15 is a graph illustrating the light output of a flat-panel area illumination system according to the embodiment of Fig. 9;
Fig. 16 is a graph illustrating the light output of an other OLED flat-panel lamp;
Fig. 17 is a schematic diagram showing a flat-panel area illumination system according to the alternative embodiment of Figs. 6a-6b;
Fig. 18 is a schematic diagram showing a flat-panel area illumination system according to the alternative embodiment of Figs. 6c-6d;
Fig. 19 is a schematic diagram showing a flat-panel area illumination system including a diffuser according to an alternative embodiment of the present invention; and
Fig. 20 is a schematic diagram of a prior-art OLED flat-panel lamp.

### DETAILED DESCRIPTION OF THE INVENTION

Referring to Fig 1a, a flat-panel area illumination system **10,** comprises a flat-panel lamp **12** having a substrate with one or more non-pixellated light-emitting areas **13** formed on the substrate and emitting light **30** in every direction from at least one side of the lamp **12;** and a light-directing optical film **14** located over the light emitting area **13** of the flat-panel lamp. The light-directing optical film **14** of Fig. 1 is shown in a perspective view in Fig. 3. Referring to Fig. 3, the light-directing optical film **14** includes a flat surface **40** on one side and a structured surface **42** on the other side of the light-directing optical film **14.**

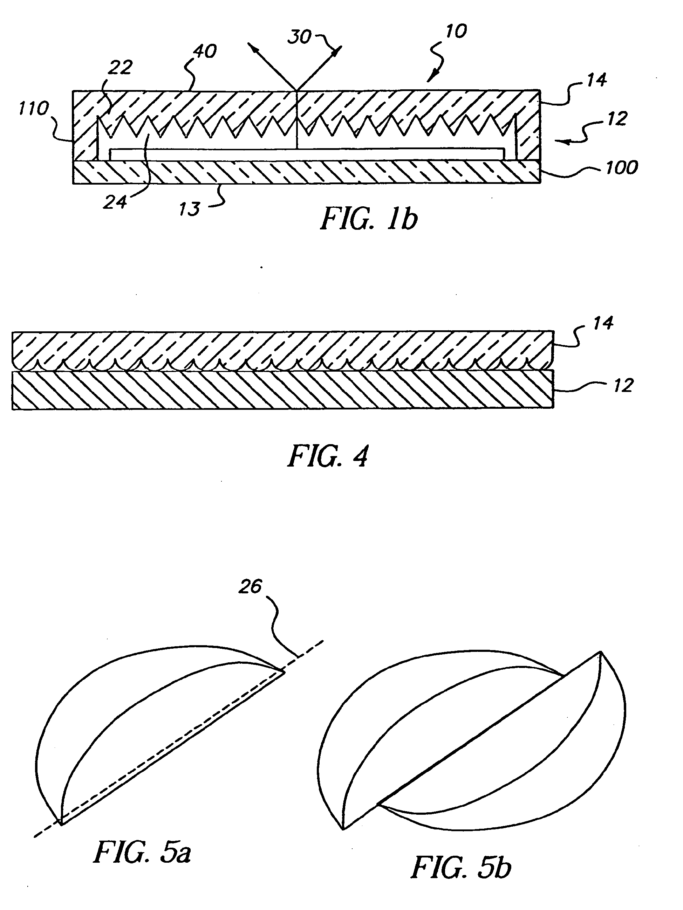

The structures **22** formed on the structured surface **42** can take a variety of shapes, for example regular triangular prisms or cylindrical lenses (shown in Figs. 3 and 4) formed in adjacent rows, such as are described in USPs 6,707,611, 6,752,505, 6,760,157. The structures **22** are much smaller than the light-emitting area **13** so that a plurality of structures is associated with each light-emitting area. The light-directing optical film **14** may be either rigid or flexible and may be made of, for example, plastic such as PET or glass, and can be constructed using a variety of techniques known in the art, for example injection roll molding and embossing. A variety of shapes and structural relationships are possible, for example the shapes of the structures may be different, may have different sizes or have portions that intersect at different angles, and may have pointed or rounded peaks or cavities.

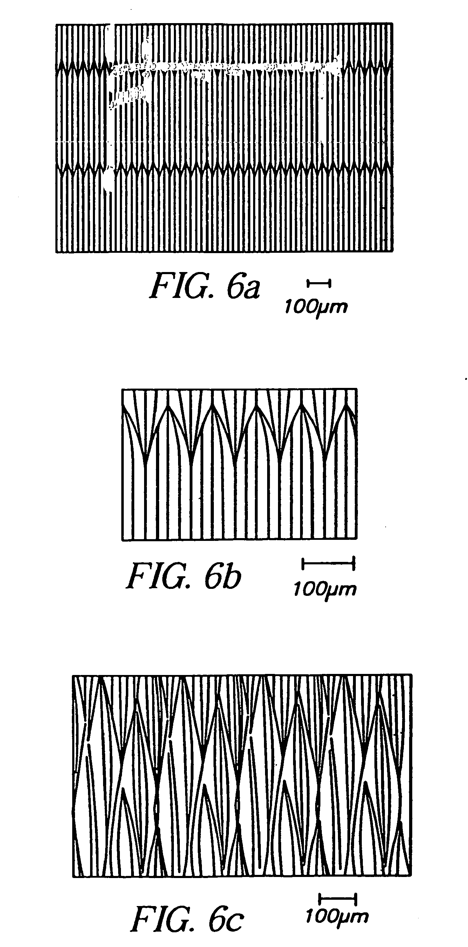

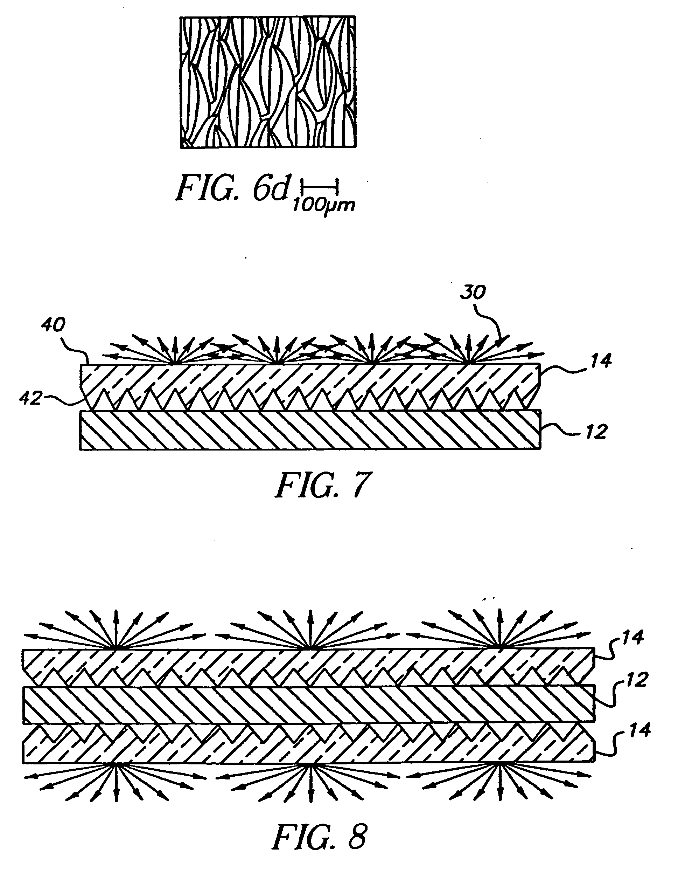

Referring to Fig. 5a, in an alternative embodiment, the structures can be wedge shaped and have a long axis **26** and in which the axes of the wedge-shaped structures are aligned in a common direction. The wedge can have a curved outside edge or may have an extensive straight portion with curves on the ends. Referring to Fig. 5b, the wedges may be formed in facing pairs. Referring to Figs. 6a and 6b, for example in photomicrographs of an alternative embodiment implemented by applicant, the wedge pairs are aligned in rows having axes formed into parallel lines. Referring to Figs. 6c and 6d, in photomicrographs of another alternative embodiment, the wedges have parallel axes but are not formed into lines and are randomly located in one dimension while they are aligned in another.

The structures **22** formed on the structured surface **42** of the light-directing optical film **14** are much smaller than the light-emitting areas **13** of the flat-panel lamp **12,** the structures serve to re-direct the light from the flat-panel lamp **12** rather than to focus the light in an image-wise fashion. The actual shape of the structures defines the nature of the light re-direction. The light-directing optical display film **14** and structures **22** are formed from a relatively high refractive index material compared to the gaps **24** formed between the structures. The gaps **24** may be, for example, air or a lower refractive index material.

The flat-panel area illumination system **10** may emit light through the substrate and the optical film may be located over the substrate (as shown in Fig. 1a). In an alternative embodiment of the present invention (shown in Fig. lb), the flat-panel area illumination system **10** may further comprise an encapsulating cover over the light emitting area and affixed to the substrate and may emit light through the cover. In this embodiment, the optical film is located over the cover or is formed in the cover (as in Fig. 1b).

The flat-panel lamp **12** may be an OLED lamp. Such a lamp may emit light from one or both sides, may be flexible or rigid and may be a bottom- or top-emitting device, as is known in the art. Fig. 1a illustrates a bottom-emitting embodiment while Fig. 1b illustrates a top-emitting embodiment.

In accordance with the invention, the light-directing optical film preferentially directs light away from a direction perpendicular to the surface of the light-emitting side of the flat-panel lamp. Referring to Fig. 7, in one embodiment of the present invention, such effect may be realized by employing the structured side **42** of the light-directing optical film **14** adjacent to the light-emitting side of the flat-panel lamp **12,** so that the structured side of the light-directing optical film receives the light emitted by the flat-panel lamp. In this configuration, the light-directing optical film **14** will direct an increased amount of light **30** away from a perpendicular to the surface of the flat-panel lamp and film. The length of each light **30** ray indicates the amount of light emitted in the direction of the ray. A shorter ray indicates that less light is emitted in that direction; a longer ray indicates that more light is emitted in that direction. This is in contrast to prior art uses of brightness enhancing and light-directing films such as described in, e.g., USPs 6,707,611, 6,752,505, 6,760,157, wherein structures are typically employed to collimate or diffuse light in various applications and are employed on the light-exiting side of the film. The present invention may be particularly useful, for example, in a flat-panel ceiling illumination system where it is desired to reduce glare from the lamps by directing the light along the ceiling toward the walls where it can be diffusely reflected into a room or hallway. The light-directing optical film may be affixed to the flat-panel lamp by adhesives applied to the peaks of the structures or around the edges of the lamp or at specific locations within the light-emitting areas of the lamp.

In an alternative embodiment illustrated in Fig. 8, a flat-panel lamp may emit light from both sides and a light-directing optical film provided on both sides of the flat-panel lamp. This arrangement is useful in a light suspended from a ceiling and efficiently providing light primarily directed to the sides. Alternatively, the films provided on each side may be different, for example the film on one side may direct light away from a normal while the film on the other side may direct light toward a normal.

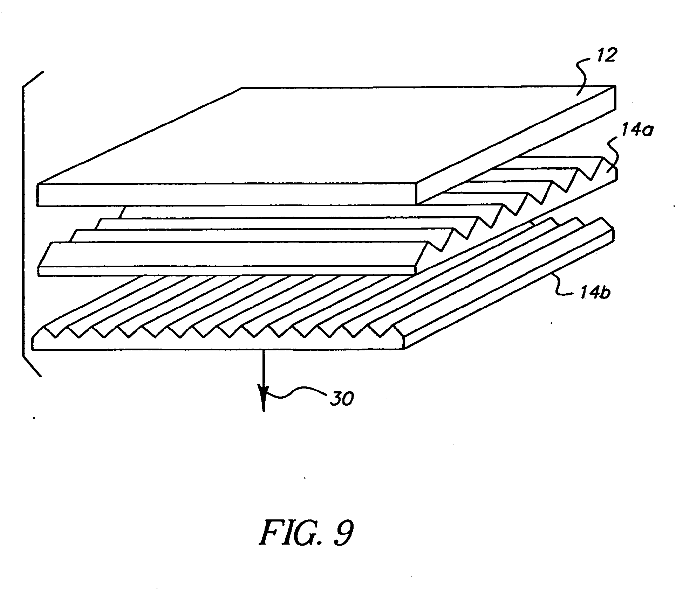

A single light-directing optical film is limited in its ability to direct light. By using a combination of films oriented in different directions, a wider variety of light-directing modalities may be obtained. For example, referring to Fig. 9, a flat-panel lamp **12** may further include a second light-directing optical film **14b** located over the light directing optical film **14a** and parallel to the light-directing optical film **14a** and wherein the structures of the second light-directing optical film **14b** are at an angle, for example 90 degrees, to the structures of the light-directing optical film **14a.** Additional light-directing optical films with structures oriented at different angles, for example multiples of 60, 45 or 30 degrees, may be stacked to provide a wider variety of light-direction modalities.

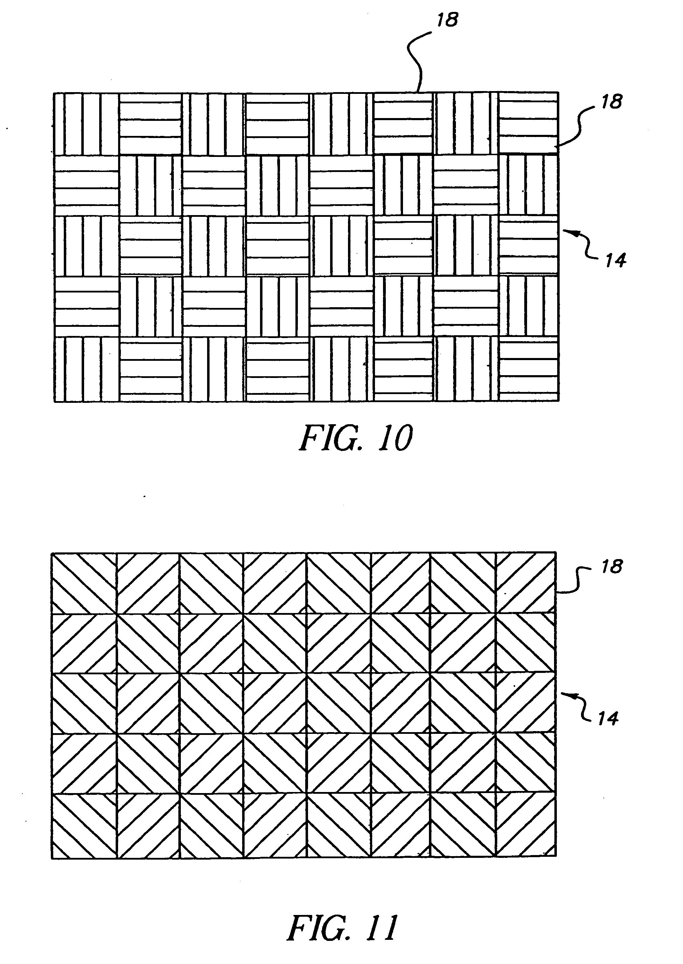

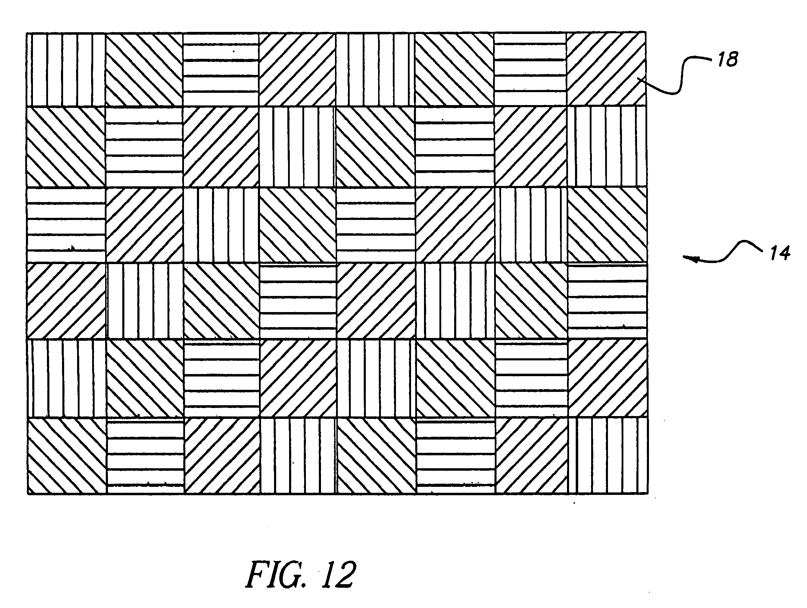

This design, while useful, has the limitation of requiring multiple films stacked over each other, increasing costs and thickness. Moreover, optical films are not perfectly clear, so that some light will be absorbed in the film, reducing the efficiency of the illumination system. Referring to Fig. 10, in an alternative embodiment of the present invention, a single light-directing optical film **14** is divided into a plurality of regions **18** and the structures in one region are oriented at a different angle from the structures in a second region. As shown in Fig. 10, the regions **18** are of two types, each type has similar structures oriented perpendicularly to the other. Each region **18** of the light-directing optical film **14** will direct light in its preferred direction. Overall, if the regions **18** are relatively small compared to the light-emitting area **13,** the light-directing properties of the regions **18** are combined. As illustrated in Fig. 10, the structures are parallel or perpendicular to the edges of the optical film. In an alternative arrangement shown in Fig. 11, the structures are at another angle with respect to the edges of the light-directing optical film and may be constructed to suit a particular application. The number of types of regions **18** is not limited to two. Referring to Fig. 12, four different light-directing regions **18** have their structures relatively oriented at 0, 45, 90, and 135 degrees to provide an emissive profile that combines the light from each region **18.** If it is desired to reduce the perceptibility of light directed by the different regions, the regions may be made small relative to the size of the flat-panel lamp and the different regions **18** may alternate over the extent of the light emitting area **30** of the flat-panel lamp **12.**

The flat-panel lamp **12** and light-directing optical film **14** comprising the illumination system of the present invention may be manufactured separately. Once manufactured, the flat-panel lamp **12** and light-directing optical film **14** may be combined, typically by adhering the film to the lamp to form a single, flat-panel device. Once integrated, the flat-panel lamp may be illuminated to provide a flat-panel area illumination system emitting light in preferred directions. Note that care must be taken to orient the system at installation to ensure that the illumination system performs as desired within a specific illuminated space. In one suitable manufacturing process, the flat-panel lamp and the light-directing optical film may be formed from a web in a continuous roll.

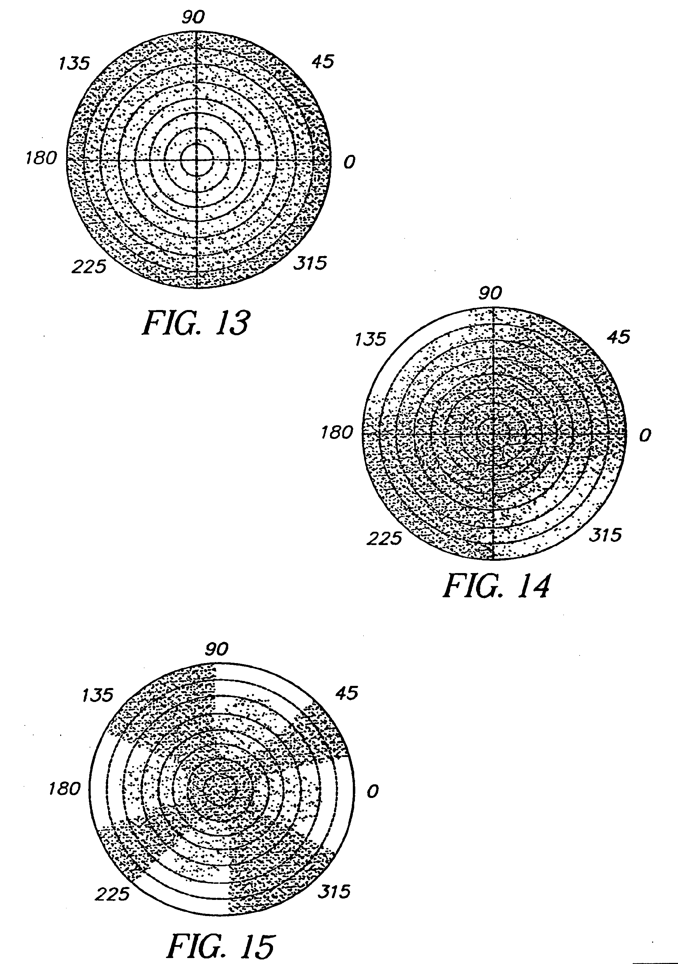

Referring to Figs. 13-15, the performance of the light-directing optical film and flat-panel lamp illustrated in Fig. la is measured. The circular graphs show the relative brightness of the illumination system over a hemisphere, so that, for example, the central point of the circle shows the amount of light emitted perpendicular to the surface of the lamp and the edges of the circle shows the amount of light emitted horizontal to the surface of the lamp and in the relative direction indicated from the center point. The lightness of the point indicates the brightness of the light; dark areas of the graph indicate that relatively little light is emitted in the corresponding direction.

Figure 13 illustrates the output of an OLED flat-panel lamp with no light-directing optical film. As can be seen from this graph, the light emitted from the lamp is relatively isotropic and has no preferred direction that is, the light emitted is substantially Lambertian; an approximately equal amount of light is emitted in every direction from every point of the light emitting surface area. In this experiment, e.g., the amount of light emitted perpendicular to the substrate is less than twice that emitted in any other direction. Referring to Fig. 14, the light output from the configuration of Figs. 1a and 7 is illustrated, employing a film having triangular prisms as illustrated in Fig. 3. As can be seen from Fig. 14, the light is preferentially directed to the sides. Relatively little light is emitted straight downwards or in the direction of the structures. In this experiment, the amount of light emitted in the preferential direction is more than a factor of ten greater than the amount of light emitted in the least preferential direction. Referring to Fig. 15, the performance of the configuration of Fig. 9 is indicated, demonstrating that a combination of separate films can effectively direct light in preferred directions, with differential performance in multiple directions.

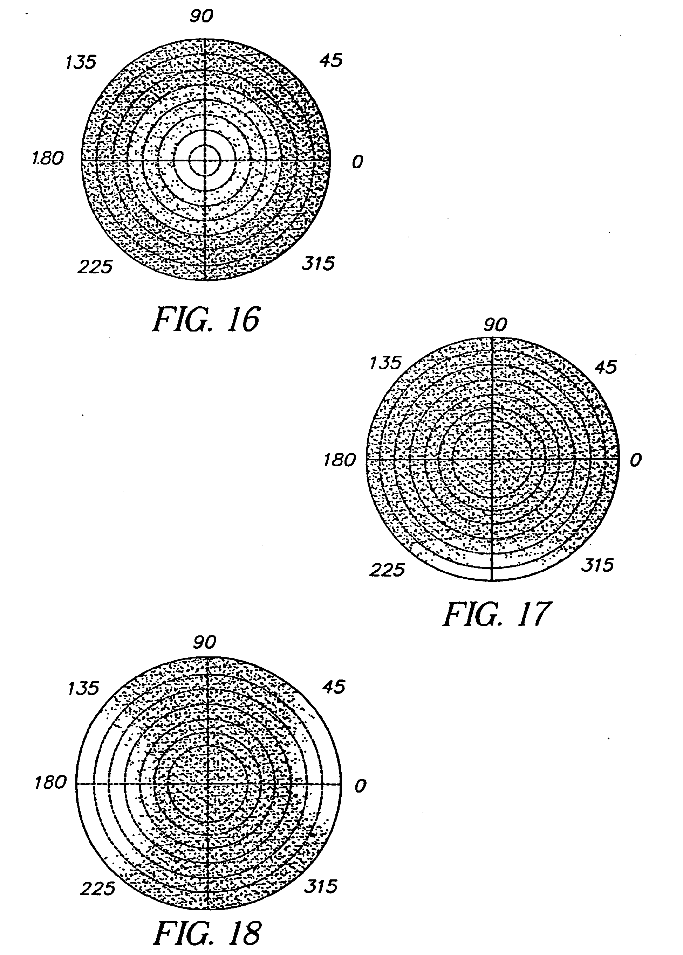

Figs. 16-18 illustrate the effect of light-directing optical films having wedge structures as shown in Figs. 6a-6d. Fig. 16 shows the performance of a second OLED flat-panel lamp with no film. Similarly as in Fig. 13, the amount of light emitted perpendicular to the substrate is less than twice that emitted in any other direction. Fig. 17 shows the performance of the same lamp with a film having wedge structures as illustrated in Figs. 6a and 6b. The performance of a film having wedge structures as illustrated in Figs. 6c and 6d is similarly shown in Fig. 18. As can be seen from Figs. 17 and 18, the light is in each instance preferentially directed to the sides. Relatively little light is emitted straight downwards or in the long axis direction of the wedge structures. In these experiments, the amount of light emitted in the preferential direction is more than a factor of five greater than the amount of light emitted in the least preferential direction.

The flat-panel area illumination system of the present invention may also include a diffuser located between the light-directing optical film and the flat-panel lamp (Fig. 19). Such diffusers may be useful in reducing any angular dependence on color that may be found in the light emitted from the flat-panel lamp chromaticity, may reduce the appearance of non-uniformities in the light emitted from the lamp, or may improve the amount of light emitted from the flat-panel lamp.

The present invention may be used in conjunction with any flat panel lamp, including but not limited to OLED lamps.

### PARTS LIST

- 10: flat-panel lighting system
- 12: flat-panel lamp
- 13: light-emitting area
- 14: light-directing optical film
- 14a: light-directing optical film
- 14b: light-directing optical film
- 18: region of light-directing optical film
- 20: diffuser
- 22: high refractive index material structures
- 24: low refractive index material gaps
- 26: axis
- 30: light
- 40: flat side
- 42: structured side
- 100: substrate
- 102: electrode
- 104: organic layer(s)
- 106: electrode
- 110: encapsulating cover

## Claims

1. A flat-panel area illumination system, comprising:
a) a flat-panel lamp having a substrate and one or more non-pixellated light-emitting areas formed on the substrate emitting light in every direction from at least one light-emitting side of the lamp; and
b) a light-directing optical film located on the at least one light-emitting side over the light-emitting area of the flat-panel lamp, wherein the light-directing optical film preferentially directs light away from a direction perpendicular to the surface of the light-emitting side of the flat-panel lamp.

2. The flat-panel area illumination system claimed in claim 1, wherein the light-directing optical film includes a structured surface located adjacent to the light-emitting side of the flat-panel lamp.

3. The flat-panel area illumination system claimed in claim 2, wherein the light-directing optical film includes a flat surface located opposite to the light-emitting side of the flat-panel lamp.

4. The flat-panel area illumination system claimed in claim 3, wherein the structured surface comprises triangular prisms.

5. The flat-panel area illumination system claimed in claim 3, wherein the structured surface comprises cylindrical lenses.

6. The flat-panel area illumination system claimed in claim 3, wherein the structured surface comprises a plurality of wedge-shaped structures having a long axis and in which the axes of the wedge-shaped structures are aligned in a common direction.

7. The flat-panel area illumination system of claim 1, wherein the flat-panel lamp is an OLED lamp.

8. The flat-panel area illumination system of claim 1, further comprising a diffuser located between the light-directing optical film and the flat-panel lamp.

9. The flat-panel area illumination system of claim 1, further comprising a second light-directing optical film located over the light directing optical film and parallel to the light-directing optical film

10. The flat-panel area illumination system of claim 1, wherein the light-directing optical film is divided into a plurality of regions and light-directing structures in one region are oriented at a different angle from light-directing structures in a second region.

## Patentansprüche

1. Flaches Flächenbeleuchtungssystem, mit:
a) einer flächigen Leuchte, die ein Substrat und mindestens einen auf dem Substrat ausgebildeten, nicht gepixelten, Licht ausstrahlenden Bereich aufweist, der Licht von mindestens einer Licht ausstrahlenden Seite der Leuchte aus in jede Richtung ausstrahlt; und
b) einer Licht lenkenden, optischen Schicht, die auf der mindestens einen Licht ausstrahlenden Seite über dem Licht ausstrahlenden Bereich der flächigen Leuchte angeordnet ist, worin die Licht lenkende, optische Schicht vorzugsweise Licht aus einer Richtung weglenkt, die rechtwinklig zur Fläche der Licht ausstrahlenden Seite der flächigen Leuchte verläuft.

2. Flaches Flächenbeleuchtungssystem nach Anspruch 1, worin die Licht lenkende, optische Schicht eine strukturierte Oberfläche aufweist, die der Licht ausstrahlenden Seite der flächigen Leuchte benachbart angeordnet ist.

3. Flaches Flächenbeleuchtungssystem nach Anspruch 2, worin die Licht lenkende, optische Schicht eine plane Oberfläche aufweist, die der Licht ausstrahlenden Seite der flächigen Leuchte gegenüber angeordnet ist.

4. Flaches Flächenbeleuchtungssystem nach Anspruch 3, worin die strukturierte Oberfläche dreieckige Prismen aufweist.

5. Flaches Flächenbeleuchtungssystem nach Anspruch 3, worin die strukturierte Oberfläche zylindrische Linsen aufweist.

6. Flaches Flächenbeleuchtungssystem nach Anspruch 3, worin die strukturierte Oberfläche eine Vielzahl keilförmiger Strukturen aufweist, die eine lange Achse aufweisen, wobei die Achsen der keilförmigen Strukturen in einer gemeinsamen Richtung ausgerichtet sind.

7. Flaches Flächenbeleuchtungssystem nach Anspruch 1, worin die flächige Leuchte eine OLED Leuchte ist.

8. Flaches Flächenbeleuchtungssystem nach Anspruch 1, mit einem Diffusor, der zwischen der Licht lenkenden, optischen Schicht und der flächigen Leuchte angeordnet ist.

9. Flaches Flächenbeleuchtungssystem nach Anspruch 1, mit einer zweiten, Licht lenkenden, optischen Schicht, die über der Licht lenkenden optischen Schicht und parallel zur Licht lenkenden optischen Schicht angeordnet ist.

10. Flaches Flächenbeleuchtungssystem nach Anspruch 1, worin die Licht lenkende optische Schicht in eine Vielzahl von Bereichen unterteilt ist und Licht lenkende Strukturen in einem Bereich in einem Winkel ausgerichtet sind, der sich von dem Winkel Licht lenkender Strukturen in einem zweiten Bereich unterscheidet.

## Revendications

1. Système d'éclairage à panneau plat comprenant :
a) une lampe à panneau plat comprenant un substrat et une ou plusieurs zones électroluminescentes non pixellisées formées sur le substrat, émettant de la lumière dans toutes les directions à partir d'au moins une face de la lampe électroluminescente; et
b) un film optique orientant la lumière situé sur la au moins une face électroluminescente sur la zone électroluminescente de la lampe à panneau plat, où le film optique orientant la lumière oriente de préférence la lumière de manière à l'éloigner d'une direction perpendiculaire à la surface de la face électroluminescente de la lampe à panneau plat.

2. Système d'éclairage à panneau plat selon la revendication 1, dans lequel le film optique orientant la lumière comprend une surface structurée adjacente à la face électroluminescente de la lampe à panneau plat.

3. Système d'éclairage à panneau plat selon la revendication 2, dans lequel le film optique orientant la lumière comprend une surface plane située à l'opposé de la face électroluminescente de la lampe à panneau plat.

4. Système d'éclairage à panneau plat selon la revendication 3, dans lequel la surface structurée comprend des prismes triangulaires.

5. Système d'éclairage à panneau plat selon la revendication 3, dans lequel la surface structurée comprend des lentilles cylindriques.

6. Système d'éclairage à panneau plat selon la revendication 3, dans lequel la surface structurée comprend une pluralité de structures cunéiformes ayant un axe long et où les axes des structures cunéiformes sont alignés dans une direction commune.

7. Système d'éclairage à panneau plat selon la revendication 1, dans lequel la lampe à panneau plat est une lampe DELO.

8. Système d'éclairage à panneau plat selon la revendication 1 comprenant en outre un diffuseur situé entre le film optique orientant la lumière et la lampe à panneau plat.

9. Système d'éclairage à panneau plat selon la revendication 1 comprenant en outre un second film optique orientant la lumière situé sur le film optique orientant la lumière et parallèle au film optique orientant la lumière.

10. Système d'éclairage à panneau plat selon la revendication 1, dans lequel le film optique orientant la lumière est divisé en une pluralité de régions et les structures orientant la lumière d'une région sont orientées selon un angle différent par rapport aux structures orientant la lumière d'une seconde région.
